(19) Europäisches Patentamt / European Patent Office / Office européen des brevets

(11) EP 4 571 280 A1

(12) DEMANDE DE BREVET EUROPEEN

(43) Date de publication:
18.06.2025 Bulletin 2025/25

(21) Numéro de dépôt: 24218721.9

(22) Date de dépôt: 10.12.2024

(51) Classification Internationale des Brevets (IPC):
*G01K 11/3213* (2021.01)

(52) Classification Coopérative des Brevets (CPC):
G01K 11/3213

(84) Etats contractants désignés:
AL AT BE BG CH CY CZ DE DK EE ES FI FR GB GR HR HU IE IS IT LI LT LU LV MC ME MK MT NL NO PL PT RO RS SE SI SK SM TR
Etats d'extension désignés:
BA
Etats de validation désignés:
GE KH MA MD TN

(30) Priorité: 12.12.2023 FR 2314028

(71) Demandeur: **Commissariat à l'Energie Atomique et aux Energies Alternatives**
**75015 Paris (FR)**

(72) Inventeur: **RACCURT, Olivier**
**38054 GRENOBLE CEDEX 09 (FR)**

(74) Mandataire: **Cabinet Nony**
**11 rue Saint-Georges**
**75009 Paris (FR)**

(54) **CAPTEUR DE TEMPÉRATURE ET DE MESURE DE L'ÉTAT DE CHARGE (SOC) D'UN ACCUMULATEUR**

(57) Capteur de température et de mesure de l'état de charge (SOC) d'un accumulateur à fibre optique à matériau(x) thermo-luminescent(s), au(x) pic(s) d'émission dans une zone de variation du spectre d'absorption optique du matériau d'insertion d'une électrode L'invention concerne un capteur (7) de température et de mesure de l'état de charge (SOC) d'un accumulateur métal-ion, comprenant une fibre optique (8) dont une extrémité libre (82) forme une sonde optique (9) à matériau(x) thermo-luminescent(s) (91) susceptible(s) d'émettre un pic de lumière à au moins deux longueurs d'ondes, au moins un des deux pics étant adapté pour être dans au moins une zone de variation du spectre d'absorption optique du matériau d'insertion des ions métal d'au moins une électrode de l'accumulateur, le rapport des deux pics étant fonction de la température de l'accumulateur et la variation d'intensité d'au moins un des deux pics étant fonction de l'insertion des ions métal dans l'électrode.

[Fig 12]

Gamme de forte variation de l'absorption en fonction de l'état lithiation du graphite

Fig. 12

EP 4 571 280 A1

## Description

### Domaine technique

La présente invention concerne le domaine de l'instrumentation, notamment des capteurs de mesure d'un paramètre de fonctionnement d'un accumulateur ou batterie.

Elle concerne plus particulièrement les capteurs à fibre optique adaptés pour une telle mesure.

L'invention vise à proposer une solution pour estimer à la fois la température et l'état de charge d'une batterie, à partir d'un unique capteur à fibre optique.

L'invention est décrite en référence à une utilisation pour la mesure au sein d'accumulateurs électrochimiques ou batteries, notamment de type métal-ion, afin d'estimer le plus rapidement possible la température et simultanément le paramètre de fonctionnement qu'est l'état de charge (SOC acronyme anglo-saxon pour « State Of Charge »).

Bien que décrite en référence à un accumulateur Lithium-ion, l'invention s'applique à des mesures de température de tout accumulateur électrochimique métal-ion, c'est-à-dire également les accumulateurs sodium-ion, Magnésium-ion, Aluminium-ion...ou de manière plus générale à tout accumulateur électrochimique dont le matériau d'anode ou de cathode a une absorption optique qui change avec son état de charge.

De manière générale, un capteur selon l'invention peut être mis en oeuvre dans n'importe quelle application industrielle, médicale, biologique nécessitant, à un moment ou à un autre, la détermination d'une température, notamment dans une gamme de -180°C à 400°C.

Par « thermoluminescence », on entend ici et dans le cadre de l'invention, la capacité d'un matériau à émettre quasiment instantanément, à une température donnée et sous l'effet d'un rayonnement lumineux dit rayonnement d'absorption ou d'excitation, un rayonnement lumineux de même longueur d'onde ou de longueur d'onde différente dit rayonnement d'émission.

Le rayonnement lumineux émis par le matériau thermo-luminescent est caractérisé par un spectre d'émission comportant un ou plusieurs pics dont l'intensité et ou le temps de vie de luminescence varie en fonction de la température, à laquelle le matériau est soumis.

### Technique antérieure

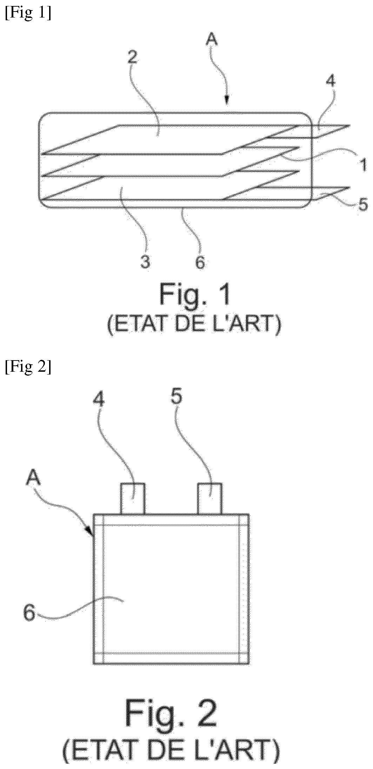

Telle qu'illustrée schématiquement en figures 1 et 2, une batterie ou accumulateur lithium-ion comporte usuellement au moins une cellule électrochimique constituée d'un constituant d'électrolyte 1 entre une électrode positive ou cathode 2 et une électrode négative ou anode 3, un collecteur de courant 4 connecté à la cathode 2, un collecteur de courant 5 connecté à l'anode 3 et enfin, un emballage 6 agencé pour contenir la cellule électrochimique avec étanchéité tout en étant traversé par une partie des collecteurs de courant 4, 5.

L'architecture des batteries lithium-ion conventionnelles comporte une anode, une cathode et un électrolyte. Plusieurs types de géométrie d'architecture conventionnelle sont connus :

- une géométrie cylindrique telle que divulguée dans la demande de brevet US2006/0121348,

- une géométrie prismatique telle que divulguée dans les brevets US 7348098, US 7338733;

- une géométrie en empilement telle que divulguée dans les demandes de brevet US2008/060189, US 2008/0057392, et brevet US 7335448.

Le constituant d'électrolyte 1 peut être de forme solide, liquide ou gel. Sous cette dernière forme, le constituant peut comprendre un séparateur en polymère, en céramique ou en composite microporeux imbibé d'électrolyte (s) organique (s) ou de type liquide ionique qui permet le déplacement de l'ion Lithium de la cathode à l'anode pour une charge et inversement pour une décharge, ce qui génère le courant. L'électrolyte est en général un mélange de solvants organiques, par exemple des carbonates dans lesquels est ajouté un sel de lithium typiquement LiPF6.

L'électrode positive ou cathode 2 est constituée de matériaux d'insertion du cation Lithium qui sont en général composite, comme Lithium-Fer-Phosphate (Li-FePO$_4$ ou LFP), LiCoO$_2$, nickel-manganèse-cobalt (NMC) dont LiNi$_{0.33}$Mn$_{0.33}$Co$_{0.33}$O$_2$, ou encore nickel-cobalt-aluminium (NCA).

L'électrode négative ou anode 3 est très souvent constituée de carbone graphite ou en Li$_4$TiO$_5$O$_{12}$ (matériau titanate), éventuellement également à base de silicium ou de composite formé à base de silicium.

Le collecteur de courant 4 connecté à l'électrode positive est en général en aluminium.

Le collecteur de courant 5 connecté à l'électrode négative est en général en cuivre, en cuivre nickelé ou en aluminium.

Une batterie ou accumulateur lithium-ion peut comporter bien évidemment une pluralité de cellules électrochimiques qui sont empilées les unes sur les autres.

Traditionnellement, une batterie ou accumulateur Li-ion utilise un couple de matériaux à l'anode et à la cathode lui permettant de fonctionner à un niveau de tension élevé, typiquement égal à 3,6 Volt.

Il est primordial de pouvoir mesurer en temps réel un certain nombre de paramètres d'un accumulateur lithium-ion afin d'optimiser son fonctionnement, sa performance, sa sécurité et son vieillissement.

Un BMS (acronyme anglais de « Battery Management System ») est utilisé à l'échelle d'un accumulateurs ou d'un ensemble d'accumulateur dans le cas d'un module ou d'un pack batterie, afin de protéger les éléments de facteurs augmentant leur dangerosité, tel des courants trop élevés, des potentiels non adaptés (trop élevés ou trop faibles), des températures limites et a donc notamment pour fonction d'arrêter les applications de courant dès l'atteinte de valeurs de tension seuil, i.e. une différence de potentiels entre les deux matériaux d'insertion actifs.

Le BMS stoppe donc les applications de courant (charge, décharge) dès l'atteinte de tensions (différence des potentiels des deux matériaux actifs) seuils. Or, les potentiels des matériaux actifs, non mesurables par le BMS, n'atteignent plus les valeurs seuils des états de charge initiaux extrêmes de l'accumulateur (0 et 100%) en raison du manque d'ions lithium échangeables. Les applications de courant ne sont pas stoppées assez tôt dans les états de charge extrême, ce qui induit également des surtensions sur les matériaux actifs, entrainant leurs dégradations structurales et chimiques.

Pour pouvoir fonctionné de façon optimale, un BMS a besoin de mesures en temps réels de paramètres physique de la tels que la tension, le courant, la température.

Cependant, la tendance est à multiplier les grandeurs à mesurer pour améliorer les performances des BMS. On peut citer par exemple la feuille de route européenne Battery2030+ qui est actée dans ce sens : [1].

Actuellement, il est difficile d'avoir accès à un certain nombre de paramètres internes d'un accumulateur tels que la température et le potentiel des électrodes par des mesures externes.

C'est pourquoi de nombreux travaux, notamment le projet ISNTABAT: [2], portent sur le développement de capteurs qui peuvent être implantés au sein d'un accumulateur.

Les capteurs à fibre optique présentent de nombreux avantages dont celui de pouvoir être miniaturisés et donc de pouvoir être implantés dans un environnement contraint en termes d'espace disponible. Ils sont en outre non conducteurs électriques et permettent d'exploiter les propriétés de la lumière pour sonder différents paramètres physiques ou chimiques au coeur d'un élément, notamment d'un accumulateur ou batterie : [3], [4], [5].

Parmi ces paramètres, la température d'un accumulateur, et l'état de lithiation d'une électrode ont déjà été sondés avec des capteurs à fibre optique

Les capteurs à fibre optique à base de particules thermo-luminescentes existants mettent en oeuvre un principe de thermoluminescence par ratiométrie de pics d'émission.

Selon ce principe, un matériau luminescent présente un spectre d'émission à plusieurs pics à des longueurs d'onde distinctes, dont au moins un a une intensité qui varie avec la température alors que d'autres vont rester constants.

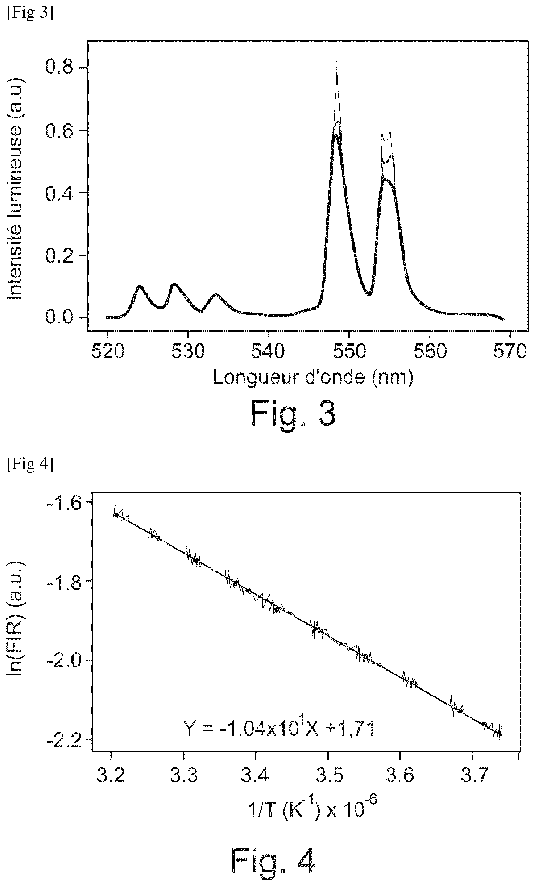

La figure 3 illustre le spectre de luminescence d'un capteur à fibre optique base de particules thermo-luminescentes dont les deux pics d'émission évoluent en fonction de la température à laquelle elles sont soumises.

Si l'on choisit parmi les pics ayant un couplage thermique un pic constant et un pic dépendant de la température on peut alors remonter à la mesure de température par la mesure de luminescence en utilisant la relation selon l'équation 1 comme suit :

[Equation 1]

$$\ln(FIR) = -\frac{\Delta E}{k_B}\left(\frac{1}{T}\right) + \ln(B)$$

dans laquelle

- FIR est le rapport d'intensité (ou des intégrales) des deux pics d'émission,
- T est la température,
- $k_B$ est la constante de Boltzmann,
- ΔE est l'écart d'énergie entre les deux niveaux d'énergie correspondant aux deux pics de luminescence et qui sont thermiquement couplés,
- B une constante.

On obtient en traçant le rapport des intensité des deux pics en fonction de l'inverse de la température une droite de coefficient directeur - $\frac{\Delta E}{k_B}$ , qui est une constante dépendant uniquement de la sonde luminescente utilisée.

Cette réponse logarithmique du capteur selon la figure 3 est illustrée à la figure 4.

Une réalisation classique d'un capteur à fibre optique à base de particules thermo-luminescentes, consiste à réaliser une sonde à base desdites particules déposée à une extrémité d'une fibre optique et/ou sur des sites sur la longueur d'une fibre optique par un procédé sol-gel.

En fonctionnement, un rayonnement lumineux d'absorption ou d'excitation est envoyé à travers la fibre optique pour atteindre la sonde. Le rayonnement d'émission résultant est récupéré et renvoyé par la même fibre vers un détecteur (de type photodiode, photomultiplicateur, spectrophotomètre, etc...) qui permet la mesure du signal de fluorescence et donc la mesure de la température par traitement du signal.

Un exemple de ce type de capteur à fibre optique est décrit dans la demande de brevet EP4155700A1.

Les inventeurs ont procédé à des essais de mesure de température au cours d'un cyclage d'un accumulateur Li-ion à électrolyte liquide imprégné dans un séparateur usuel, au moyen d'un tel capteur en le positionnant entre l'électrode positive en NMC (Nickel Manganèse Cobalt) et le séparateur.

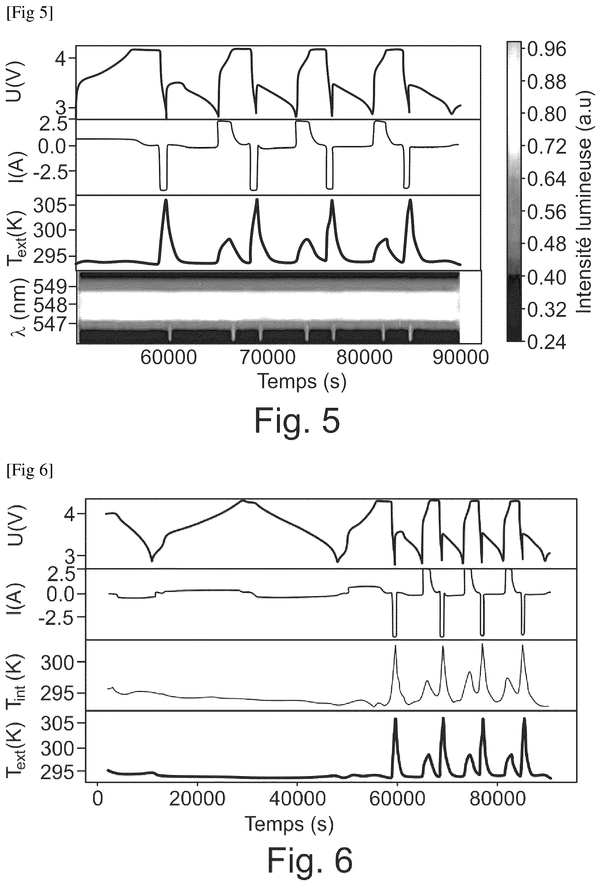

La figure 5 illustre la variation de l'intensité du signal de luminescence du capteur et la température externe de l'accumulateur li-ion de 1A.h lors d'une cyclage (charge et décharge). Les courbes indiquées sont respectivement de haut en bas, la variation de la tension, la variation du courant appliqué de l'accumulateur, la température $T_{ext}$ mesurée par thermocouple, l'intensité spectrale en fonction du temps sur une plage de longueur d'onde centrée sur le deuxième pic de luminescence qui diminue lorsque la température augmente.

La figure 6 illustre sur les deux courbes du bas la variation de la température interne $T_{int}$ mesurée donc avec un capteur selon la demande de brevet EP4155700A1, comparée à la variation de la température externe $T_{ext}$ en fonction du cyclage subi par l'accumulateur.

On constate que ces deux courbes sont quasi-identiques, ce qui indique que le capteur est fiable et précis.

Une des propriétés remarquables du graphite est que sa couleur, autrement dit son absorption optique, dépend de son état de lithiation. Cette propriété est déjà exploitée notamment pour effectuer une mesure de l'état de lithiation du graphite dans le cadre d'analyse post-mortem ou ex-situ d'une batterie.

A partir de ce constat, des chercheurs ont développé un capteur à fibre optique pour suivre le changement de couleur d'une électrode négative en graphite au sein d'un accumulateur et donc son état de lithiation à partir d'une fibre optique. Plusieurs publications sur ces travaux ont été faites : [6], [7], [8], [9], [10].

Le capteur mis en oeuvre et son fonctionnement peuvent être résumés ainsi :

- la fibre optique est préparée de façon à créer une zone permettant de générer une onde évanescente en surface. Pour cela la gaine de la fibre est retirée sur une distance de l'ordre de 1 cm. Cette onde évanescente est utilisée pour sonder la surface de l'électrode négative en graphite,
- la fibre optique est placée dans l'accumulateur de façon à être en contact avec la surface de l'électrode négative ou bien insérée dans l'épaisseur de celle-ci, (voir les figures des publications [6] et [10] pour un exemple d'implantation de la fibre optique),
- l'estimation de l'état de lithiation est réalisée en injectant une lumière qui peut être soit à large bande spectrale, par exemple générée par une lampe xénon, soit une ou plusieurs sources de lumière à bande étroite, notamment une lumière blanche, générée par des sources LED, puis en quantifiant la lumière transmise à travers la fibre et l'absorption optique au niveau de la partie de la fibre générant l'onde évanescente. En effet, comme le graphite change de couleur en fonction de son état de lithiation, il en est de même de son absorption optique.

Un tel capteur permet donc de de mesurer l'état de lithiation d'un électrode négative en graphite et de faire un suivi in situ (in operando) de l'accumulateur.

Les travaux en outre montré que la variation du spectre d'absorption optique du graphite se fait sur une assez large bande spectrale.

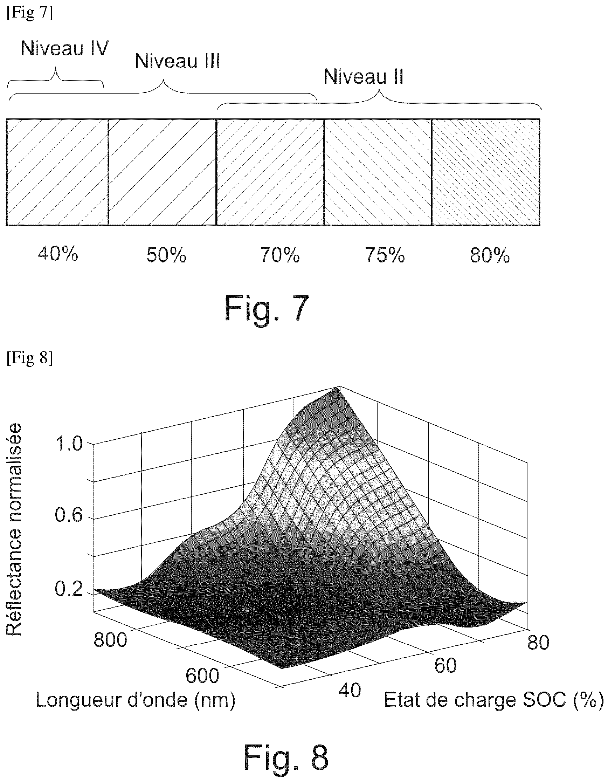

Une illustration de ces travaux est reproduite aux les figures 7, 8 et 9.

Ces figures montrent respectivement :

- la variation de la couleur du graphite en fonction de son état de lithiation (niveaux II, III et IV) et l'état de charge de l'électrode entre 40 et 80% ;

- une variation du spectre de réflectance du graphite en fonction de l'état de charge dans une gamme de longueurs d'onde entre 500 et 900 nm, mesurée par réflectance sur une électrode négative seule (post mortem),

- une variation du spectre de transmittance ($\Delta T/T$) en fonction de l'état de charge (capacité) d'un accumulateur, mesurée in-situ par onde évanescente à l'aide d'une fibre optique.

La technique par onde évanescente qui vient d'être décrite, présente de nombreux inconvénients parmi lesquels :

- la nécessité d'utiliser une source de lumière large bande ou bien des LED de longueur d'onde adaptée,

- une contrainte d'implantation de la fibre optique qui oblige à traverser l'accumulateur de part et d'autre. Or, le passage entre l'intérieur et l'extérieur d'un accumulateur est toujours critique, car il faut garantir l'étanchéité sur le long terme, sur toute la durée de vie spécifiée de l'accumulateur,

- le passage constitue un point de fragilité mécanique de la fibre optique.

Ainsi, il existe plusieurs capteurs types à fibre optique exploitant différents phénomènes optiques.

Cependant, il n'en existe que très peu capables de mesurer de façon simultanée plusieurs propriétés au sein d'un accumulateur ou batterie.

En particulier, le suivi de façon simultanée de la température interne et du potentiel ou de l'état de lithiation d'une électrode d'accumulateur avec un seul capteur n'a jamais été réalisé.

Il existe donc un besoin de proposer un tel capteur combinant la mesure de température l'état de lithiation d'une électrode d'accumulateur,

Le but de l'invention est de répondre au moins en partie à ce besoin.

**Exposé de l'invention**

Pour ce faire, l'invention a pour objet un capteur de température et de mesure de l'état de charge (SOC) d'un accumulateur notamment métal-ion, comprenant une fibre optique dont une extrémité libre forme une sonde optique à matériau(x) thermo-luminescent(s) susceptible(s) d'émettre un pic de lumière à au moins deux longueurs d'ondes, au moins un des pics étant adapté pour être dans au moins une zone de variation du spectre d'absorption optique du matériau d'insertion des ions métal d'au moins une électrode de l'accumulateur.

Avantageusement, la longueur d'onde d'un des deux pics d'émission est au-dessus de 700 nm, de préférence entre 700 et 1100 nm, tandis que celle de l'autre des deux pics d'émission est au-dessous de 700 nm, de préférence entre 400 et 600 nm.

Selon une variante de réalisation, la sonde optique comprend une matrice dans laquelle sont incorporées des particules en au moins un matériau thermo-luminescent.

De préférence, le matériau thermo-luminescent est Gd2O2S ou $Y_2O_2S$ dopé Er3+ et Yb3+.

L'invention a également pour objet un accumulateur (A) ou batterie métal-ion, notamment li-ion, comprenant, inséré en son sein, au moins un capteur tel que décrit précédemment.

Plusieurs variantes d'implantation de capteur peuvent être envisagées :

- le capteur peut être directement en contact avec l'électrode dont l'état de lithiation varie ;
- le capteur peut être directement en contact avec la face du séparateur de l'accumulateur qui est opposée à celle en contact avec l'électrode dont l'état de lithiation varie ;
- le capteur peut être inséré dans le séparateur ou pris en sandwich entre deux couches de séparateur de l'accumulateur.

L'invention a également pour objet l'utilisation d'un capteur tel que décrit précédemment pour la mesure de température simultanée à la mesure de l'état d'insertion des ions au sein d'un accumulateur métal-ion, notamment de l'état de lithiation d'une électrode négative en graphite d'un accumulateur Li-ion.

Ainsi, l'invention consiste essentiellement en un capteur de température à fibre optique portant en bout une sonde optique à matériau(x) thermo-luminescent(s) à au moins deux pics d'émission, c'est-à-dire deux pics dans au moins deux longueurs d'ondes différentes, dont un qui se situent dans au moins une zone de variation du spectre d'absorption optique du matériau d'insertion des ions métal d'au moins une électrode de l'accumulateur, le rapport des deux pics étant fonction de la température de l'accumulateur et la variation d'intensité d'au moins un des deux pics étant fonction de l'insertion des ions métal dans l'électrode.

Grâce à l'invention, un même capteur à fibre optique dont la sonde est thermoluminescence permet à la fois de faire une mesure de la température interne de l'accumulateur et une mesure par absorption de luminescence du changement de l'insertion des ions, en particulier d'une lithiation d'une électrode, notamment en graphite, pour un accumulateur Li-ion, qui est une méthode pour estimer l'état de charge de l'accumulateur (SOC).

Le principe de fonctionnement d'un capteur à sonde optique selon l'invention est le suivant.

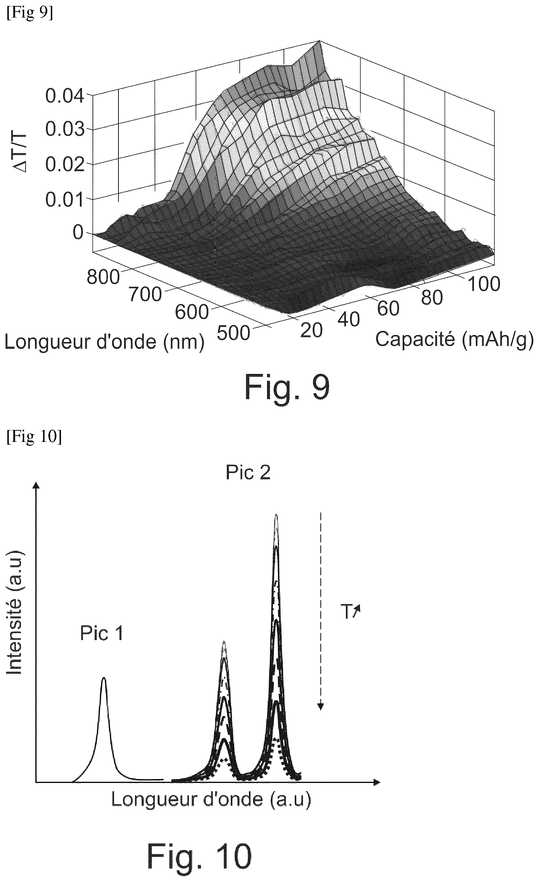

La sonde à matériau(x) thermo-luminescent(s) fonctionne par ratiométrie. La sonde selon l'invention présente deux pics de transition dans le spectre de luminescence, qui servent à la mesure. Le premier pic (Pic 1) reste constant lorsque la température change alors que le deuxième pic (Pic 2) diminue lorsque la température augmente (figure 10). Il peut y avoir des cas où le premier pic (Pic 1) varie également mais dans tous les cas c'est le rapport des deux pics qui varie en fonction de la température, comme expliqué en préambule.

Une fois la sonde positionnée de façon à interagir optiquement avec l'électrode en matériau d'insertion en ions, tel que le graphite, la lumière qu'elle va émettre par le(s) matériau(x) luminescent(s) va être absorbée par cette électrode et cette absorption va dépendre de la longueur d'onde du pic mais aussi de l'état d'insertion, de la lithiation du graphite dans le cas d'une électrode négative en graphite dans un accumulateur Li-ion. Donc, en considérant que la température ne varie pas et que l'on mesure le spectre émis par la sonde en fonction de l'état d'insertion, seule la lumière non absorbée peut être mesurée et celle-ci dépend de l'état d'insertion, en particulier de lithiation du graphite.

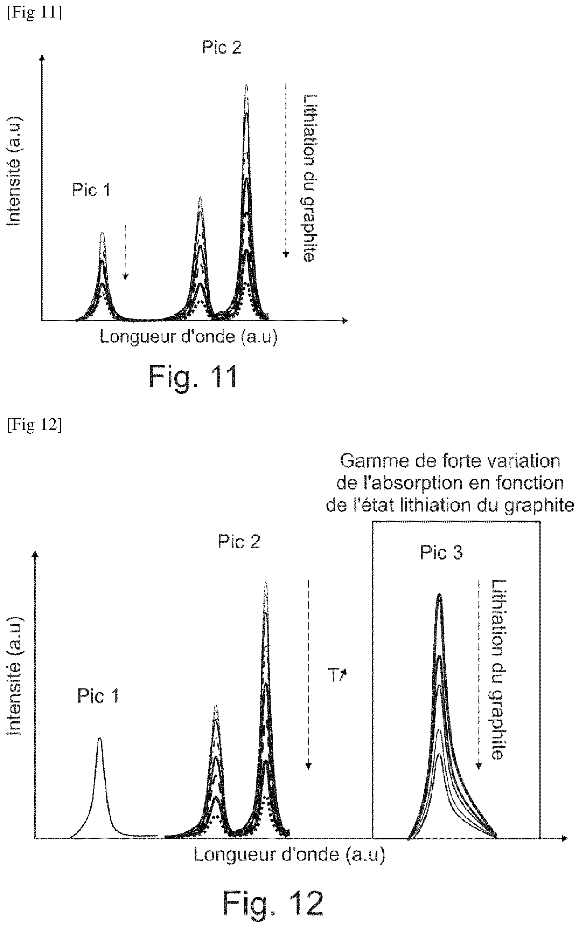

La figure 11 est vue schématique de l'évolution du spectre de luminescence mesuré en fonction de l'état de lihtiation du graphite d'une électrode à température constante. En fonction de la longueur d'onde des deux pics (Pic 1, Pic 2), leurs absorption par le graphite en fonction de son état de lithiation ne va pas varier dans la même proportion. En mesurant la variation d'intensité de l'un des pics (Pic 1 ou Pic 2), ou des deux pics (Pic 1, Pic 2), on peut ainsi suivre l'état de lithiation du graphite, et donc l'état de charge (SOC) d'un accumulateur Li-ion.

Cela étant, comme expliqué en préambule en relation avec la figure 6, la température varie au sein d'un accumulateur lors de son cyclage et en fonction du régime de courant appliqué.

Par conséquent, en positionnant une sonde à matériau(x) thermo-luminescent(s) à proximité d'une électrode d'accumulateur, notamment en graphite, de telle sorte que sa luminescence soit absorbée par le matériau d'insertion, tel que le graphite, le capteur à sonde permet à la fois de suivre l'état d'insertion du matériau d'électrode, en particulier de la lithiation du graphite et de mesurer la température au sein de l'accumulateur.

Comme montré sur la figure 12, on peut choisir de préférence un pic (Pic 3) dans une gamme de forte absorption optique du matériau d'insertion de l'électrode.

La mesure de l'état d'insertion (lithiation du graphite pour un accumulateur Li-ion à électrode négative en graphite) se fait alors en suivant la variation d'intensité de l'un des pics (Pic 1 ou Pic 2 ou Pic 3), ou des deux pics (Pic 1, Pic 2 ou P3), alors que la variation de température va elle pouvoir être mesuré à partir du rapport des deux pics ( $\frac{Pic\ 2}{Pic\ 1}$ ).

Afin d'optimiser le fonctionnement d'un tel capteur pour un accumulateur Li-ion à électrode négative en graphite, on choisit avantageusement un ou des matériaux luminescent(s) avec un pic de luminescence (Pic 3) permettant de suivre la variation de l'état lithiation du graphite dans une plage de longueur d'onde au-dessus de 700 nm, de préférence entre 700 et 1100 nm), les deux pics (Pic 1, Pic 2) ou le pic de référence (Pic 1) dans une plage de longueur d'onde faiblement affectée par l'absorption optique du graphite, de préférence entre 400 et 600 nm pour la mesure de température.

Le Pic 3 choisi est celui d'un matériau dont la luminescence (celle du Pic 3) ne va pas ou peu varier en fonction de la température dans la gamme de variation usuelle de température d'un accumulateur en fonctionnement.

D'autre avantages et caractéristiques ressortiront mieux à la lecture de la description détaillée, faite à titre illustratif et non limitatif, en référence aux figures suivantes.

**Brève description des dessins**

[Fig 1] la figure 1 est une vue schématique en perspective éclatée montrant les différents éléments d'un accumulateur lithium-ion.

[Fig 2] la figure 2 est une vue de face montrant un accumulateur lithium-ion avec son emballage souple selon l'état de l'art.

[Fig 3] la figure 3 illustre sous forme le spectre de luminescence d'un capteur à fibre optique base de particules thermo-luminescentes dont les deux pics d'émission évoluent en fonction de la température à laquelle elles sont soumises.

[Fig 4] la figure 4 est la droite logarithmique de réponse du capteur selon la figure 3.

[Fig 5] la figure 5 illustre en bas la variation de l'intensité du signal de luminescence d'un capteur de luminescence et de la température externe d'un accumulateur Li-ion de 1A.h, lors d'un cyclage électrochimique (charge et décharge) qu'il subit, caractérisé par les courbes en haut de variation de la tension et du courant appliqué.

[Fig 6] la figure 6 illustre la variation de la température interne comparée à la variation de la température externe d'un accumulateur Li-ion de 1A.h en fonction du cyclage électrochimique qu'il subit, caractérisé par la courbes en haut de variation de la tension.

[Fig 7] la figure 7 est la reproduction d'une image de la surface d'une anode en graphite d'un accumulateur en fonction de son état de lithiation du graphite et l'état de charge de l'anode.

[Fig 8] la figure 8 illustre la variation du spectre de réflectance du graphite en fonction de l'état de charge dans une gamme de longueurs d'onde mesuré par réflectance sur une électrode seule (post mortem), en dehors d'une implantation dans un accumulateur.

[Fig 9] la figure 9 illustre la variation du spectre de transmitance ($\Delta$T/T) en fonction de l'état de charge (capacité) d'un accumulateur, mesurée in-situ selon l'état de l'art par onde évanescente à l'aide d'une fibre optique.

[Fig 10] la figure 10 illustre la variation du spectre d'un capteur à sonde thermo-luminescente pour la mesure de température par ratiométrie de deux pics d'émission.

[Fig 11] la figure 11 illustre la variation d'intensité des pics d'un capteur à sonde thermo-luminescente, mesurée en fonction de l'état de lithiation du graphite à température constante.

[Fig 12] la figure 12 illustre la variation de spectres d'un capteur à sonde thermo-luminescente selon l'invention capable de mesurer de façon simultanée la température par ratiométrie de luminescence (Pic 1 et Pic 2) et la variation de lithiation du graphite (Pic 3) par absorption optique.

[Fig 13] la figure 13 est une vue en coupe longitudinale d'un capteur de mesure à fibre optique à sonde thermo-luminescente selon l'invention.

[Fig 14A], [Fig 14B], [Fig 14C] les figures 14A, 14B, 14C montrent schématiquement la sonde optique du capteur selon la figure 13, lorsque l'environnement de mesure constitué par un accumulateur Li-ion a respectivement aucun impact sur la mesure lié à un changement d'absorption optique, un impact dû à la lithiation, et à la délithiation de l'électrode négative en graphite de l'accumulateur.

[Fig 14D] la figure 14D illustre la variation d'intensité des pics du capteur à sonde thermo-luminescente dans un environnement selon les figures 14B ou 14C, mesurée en fonction de l'état de lithiation du graphite à température constante.

[Fig 14E] la figure 14E illustre la variation de spectres du capteur à sonde thermo-luminescente selon l'invention dans un environnement selon les figures 14B ou 14Cn capable de mesurer de façon simultanée la température par ratiométrie de luminescence (Pic 1 et Pic 2) et la variation de lithiation du graphite (Pic 3) par absorption optique.

[Fig 15] la figure 15 est le spectre de luminescence du $Gd_2O_2S$ dopé $Er^{3+}$ et $Yb^{3+}$ sous une excitation lumineuse à 980 nm.

[Fig 16] la figure 16 est la variation du spectre de luminescence du $Gd_2O_2S$ dopé $Er^{3+}$ et $Yb^{3+}$ sous une excitation lumineuse à 980 nm, en fonction de la température.

[Fig 17A], [Fig 17B], [Fig 17C] les figures 17A, 17B, 17C illustrent différents configurations d'implantation possible d'un capteur selon l'invention au sein d'un accumulateur Li-ion.

[Fig 18] la figure 18 est un exemple de variation de l'intensité du pic S ainsi que du rapport d'intensité les pics H et S du $Gd_2O_2S$ dopé $Er^{3+}$ et $Yb^{3+}$ dont le spectre est donné à la figure 16, lors du cyclage d'un accumulateur Li-ion à électrode négative en graphite.

[Fig 19] la figure 19 est un exemple de mesure pour une décharge à 4C d'un accumulateur Li-ion à électrode négative en graphite montrant la variation de la température, la variation de l'intensité du pic H et celle du pic S ainsi que leur rapport obtenu avec une sonde à matériau $Gd_2O_2S$ dopé $Er^{3+}$ et $Yb^{3+}$ + dont le spectre est donné à la figure 16.

[Fig 20] la figure 20 est le résultat du traitement des données permettant d'extraire la contribution due à l'absorption optique du graphite d'une électrode négative d'un accumulateur Li-ion lors de la décharge à 4C pour en déduire la variation sur la variation de l'intensité du pic H. et sur la variation de l'intensité du pic S

[Fig 21] la figure 21 est le résultat du traitement des données permettant d'extraire la contribution due à l'absorption optique du graphite d'une électrode négative d'un accumulateur Li-ion lors de la décharge à 4C pour en déduire la variation sur la variation de l'intensité du pic S.

[Fig 22] la figure 22 est la corrélation entre la température externe mesurée par un thermocouple, la variation du rapport des pics H et S et de la température mesurée par un capteur à thermo-luminescence selon l'invention après le retrait de la contribution du graphite dans le signal.

## Description détaillée

Les figures 1 à 12 ont déjà été décrites en préambule. Elles ne seront donc pas détaillées par la suite.

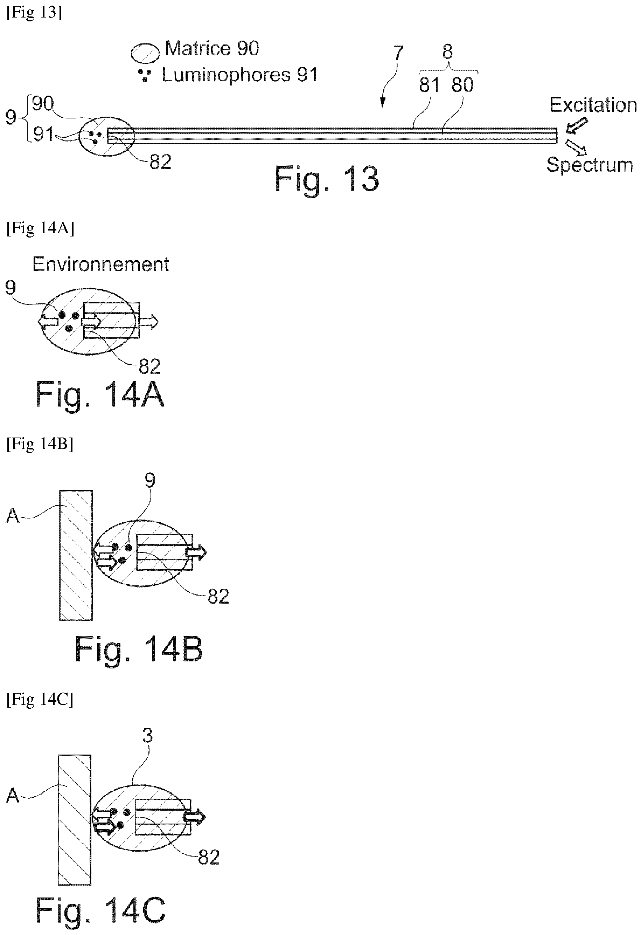

On a représenté en figure 13 un capteur de mesure 7 à fibre optique selon l'invention.

Il comprend une fibre optique 8 constituée d'un coeur 80 adapté à propager la lumière et une gaine 81 entourant le coeur.

Une extrémité libre 82 de la fibre porte une sonde optique 9 constituée d'une matrice 90 comprenant des particules thermo luminescentes aussi appelées luminophores 91.

La matrice 30 peut être un sol-gel de silice, un polymère ou tout autre matériau organique ou hybride transparent dans les gammes de longueur d'onde utilisée et qui puisse supporter l'environnement de l'électrolyte d'un accumulateur métal-ion dans lequel la fibre optique 2 et la sonde optique 3 sont plongées. Des exemples de matériaux de la matrice 30 déposés notamment par dépôt sol-gel comme décrit dans la demande de brevet EP4155700A1. La matrice peut également être en polyméthacrylate de méthyle (PMMA).

Les différentes figures 14A à 14C montrent différentes configurations dans lesquelles le capteur 7 selon l'invention fonctionne.

Pour sonder les luminophores 91, une lumière d'excitation dont la longueur d'onde dépend du type de luminophores utilisé qui est envoyé par le coeur 80 de la fibre.

Les luminophores alors excités émettent de la lumière dont le spectre d'émission avec des pics est caractéristique de la nature du luminophore.

Si la sonde optique 9 du capteur 7 est à l'extérieur ou dans un environnement sans impact optique, alors le spectre de luminescence de la sonde 9 est émis dans toutes les directions et une partie repart dans la fibre optique sans être modifié par l'environnement (figre 14A).

Lorsque la sonde optique 9 est positionnée au sein d'un accumulateur Li-ion, de façon à interagir optiquement avec le graphite de l'électrode, l'état de lithiation de celui-ci va modifier le spectre de luminescence qui est récupéré par la fibre optique 8 puisqu'une partie de celui-ci va être absorbé par le graphite (figures 14B et 14C).

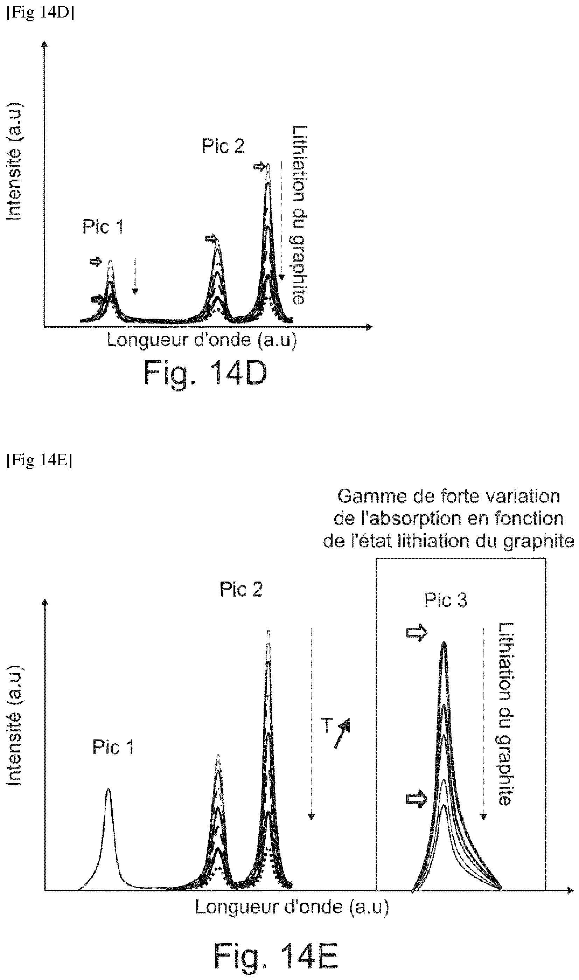

Cette différence d'absorption est alors mesurée par mesure spectrale, comme illustré aux figures 14D et 14E. On peut aussi mesurée cette différence d'absorption optique au moyen de photodétecteurs centrés sur les pics d'intérêt, Pic 1, Pic 2, Pic 3.

Les luminophores 91 peuvent être en un seul matériau thermoluminescent dont le spectre de luminescence comporte plusieurs pics dont certains sont dédiés pour la mesure de température et d'autres pour la mesure de l'état de lithiation du graphite.

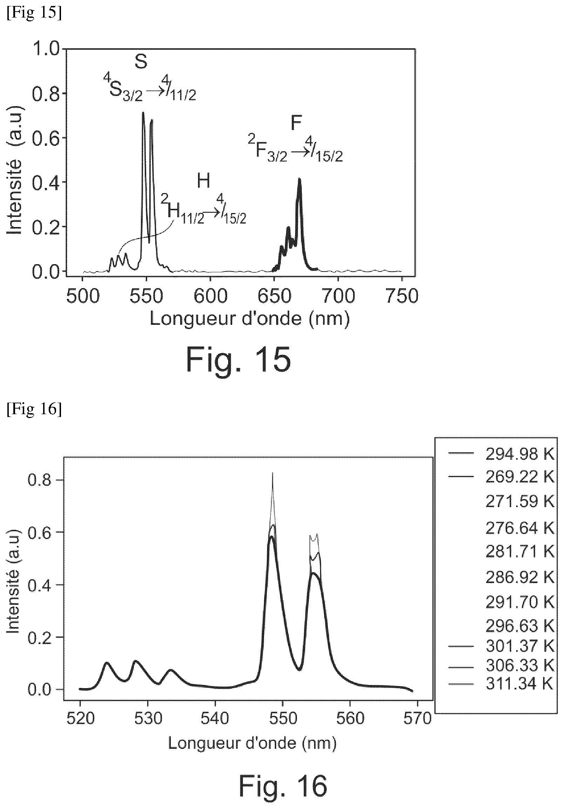

Le $Gd_2O_2S$, ou $Y_2O_2S$, ou le $NaYF_4$, ou le $NaGdF_4$, ou le $YVO_4$ dopé Er3+ et Yb3+ sont des matériaux qui conviennent parfaitement, qui peuvent être excités à une longueur d'onde de 980 ou 1500 nm. Le spectre de luminescence de $Gd_2O_2S$-$Er^{3+}$,$Yb^{3+}$,excité à 980nm est représenté sur la figure 15 : les trois pics correspondent aux transitions nommées H, S et F. Les pics ou transition S et H sont thermiquement couplés et par ratiométrie permettent de remonter à la température.

La figure 16 illustre la variation du spectre de luminescence du $Gd_2O_2S$-$Er^{3+}$,$Yb^{3+}$,sous excitation à 980 nm en fonction de la température.

Le capteur 7 selon l'invention a pour avantage primordial de pouvoir être inséré en un seul point au d'un accumulateur Li-ion dont on cherche à mesurer l'état de lithiation de l'électrode négative.

Ainsi, la sonde 9 du capteur peut être placée face à l'électrode négative en graphite, insérée dans celle-ci ou encore de l'autre côté du séparateur de l'accumulateur, à la condition que ce dernier soit transparent optiquement dans les longueurs d'onde d'intérêt pour le suivi de la lithiation du graphite. C'est par exemple le cas d'un séparateur poreux en polymère classiquement utilisé dans les accumulateurs Li-ion comme le Celgard®. Un tel séparateur imbibé d'électrolyte, est transparent et la sonde 9 du capteur peut donc mesurer l'état de lithiation de l'électrode en graphite en dessous, même avec le séparateur agencé entre les deux.

Lorsque le séparateur de l'accumulateur est transparent dans la gamme de longueurs d'onde d'intérêt pour le suivi de la lithiation du graphite, on peut aussi placer le capteur 7 dans l'épaisseur du séparateur ou alors entre deux couches successives de séparateur.

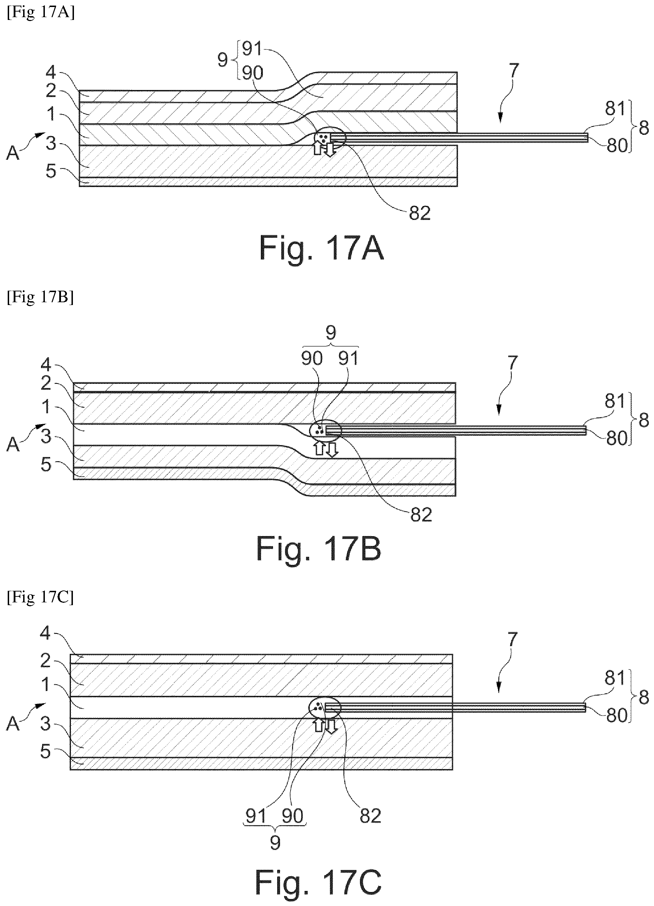

Les figures 17A, 17B et 17C montrent différentes configurations d'implantation, respectivement comme suit :

- le capteur 7 est directement en contact avec l'électrode 3 en graphite,
- le capteur 7 est directement en contact avec la face du séparateur 1 qui est opposée à celle en contact avec l'électrode 3 en graphite,
- le capteur 7 est inséré dans le séparateur ou pris en sandwich entre deux couches de séparateur.

Comme déjà mentionné, les configurations des figures 17B et 17C supposent que le séparateur 1 est transparent dans la gamme de longueurs d'onde utilisées pour suivre l'absorption du graphite.

Les inventeurs ont procédé à des essais sur un accumulateur Li-ion, à emballage souple (« pouch »), constitué d'une électrode négative en graphite, d'une électrode positive de NMC622 et d'un séparateur Celgard® dénué de revêtement.

Le capteur 7 mis en oeuvre est à matrice 90 comme décrit dans la demande de brevet EP4155700A1, dans laquelle ont été incorporées, en tant que luminophores 91, des particules de Gd2O2S dopée Er3+ et Yb3+ commercialisées sous la référence PTIR545UF par la société Phosphor Technology, dont le spectre de luminescence sous une excitation à 980 nm est donné à la figure 15.

Cette sonde optique a été positionnée au sein de l'accumulateur Li-ion.

La mesure de température a été faite en déterminant le rapport des deux pics d'émission H et S. Comme déjà évoqué, le pic H reste constant quelle que soit la température, alors que le pic S diminue lorsque la température augmente (figure 16).

Les inventeurs ont fait subir un cyclage électrochimique de charge et de décharge à régime lent à l'accumulateur.

Sous ce régime, la température de l'accumulateur n'augmente pas.

Puis, l'accumulateur a subi une décharge à 4C qui a induit une augmentation de la température de l'accumulateur d'environ 10°C.

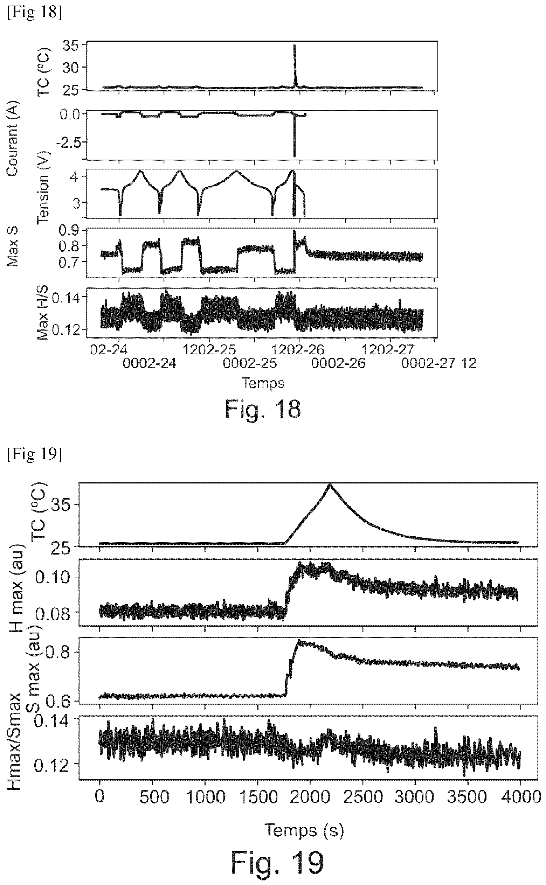

Les résultats de ces mesures sont illustrés aux figures 18 et 19.

La figure 18 montre les courbes de variation de l'intensité du pic S ainsi que du rapport d'intensité entre les pics H et S lors du cyclage à régime lent.

Il ressort que le rapport varie en fonction de la phase de charge ou de décharge de l'accumulateur (plateaux de courant) pour les faibles régimes. On voit également que la forme de l'intensité du pic S dépend du régime en charge ou en décharge et de l'intensité du courant.

Autrement dit, lorsque l'accumulateur subit le cyclage à régime lent et que la température ne change pas, la réponse du capteur optique évolue bien en fonction du cyclage. Cette évolution correspond à une variation de l'absorption optique au seins de la cellule et est corrélé à la variation de lithiation du graphite.

La figure 19 illustre, pour une décharge à 4C, la variation de la température, la variation de l'intensité de H et celle de S ainsi que le rapport entre les pics S et H.

Il ressort que les deux effets sont couplés, l'effet de la lithiation du graphite lors de la décharge sur l'intensité des pics H et S est clairement visible (augmentation puis relaxation). L'effet de la température est visible mais dans une moindre mesure sur le rapport.

En extrayant la contribution de l'absorption due à la lithiation du graphite sur le signal des pics H et S, il est possible d'extraire la contribution du signal due à la température. Pour cela on considère que l'intensité du pic H doit rester constante. On en déduit alors par différence la contribution due à l'absorption par le graphite. Cela permet ensuite de corriger la variation du pic S. Ce traitement permet d'extraire la variation du rapport entre pics S et H liée à la température.

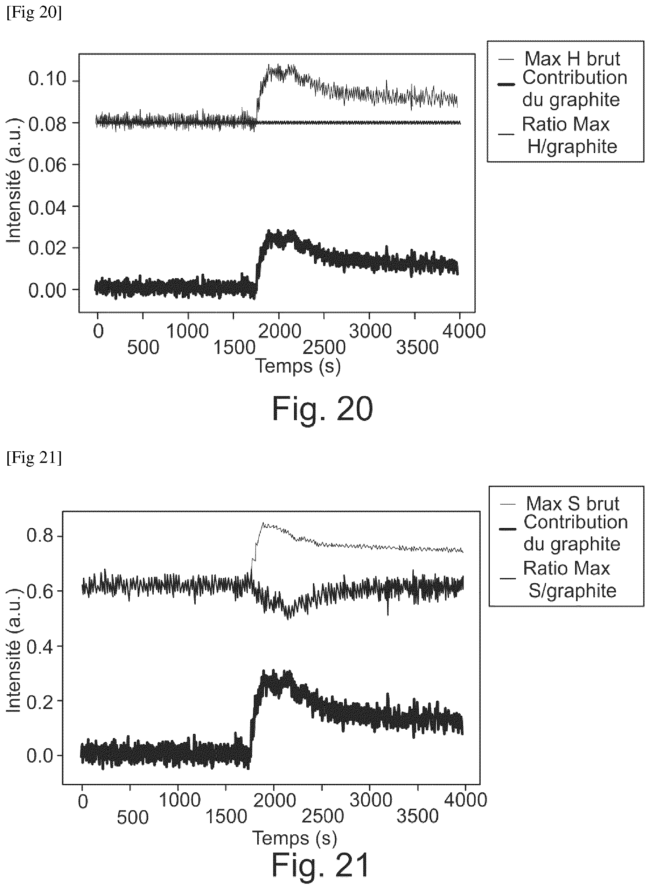

La figure 20 illustre la variation de l'intensité du pic H lors de la décharge à 4C.

La figure 21 illustre quant à elle la variation de l'intensité du pic S lors de cette même décharge.

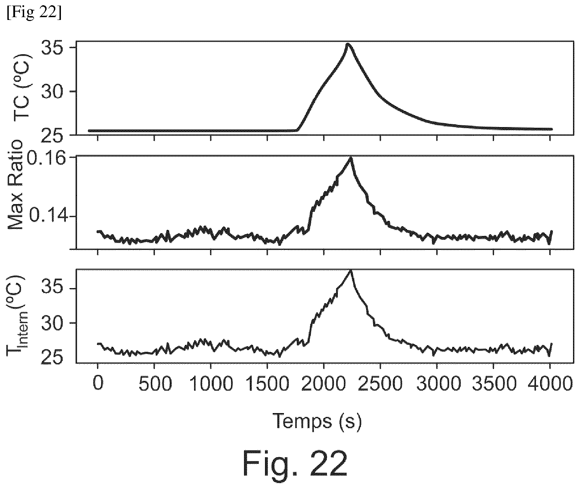

Après ce traitement de donnée, on peut établir une corrélation entre la température externe $T_{ext}$ de l'accumulateur mesurée par thermocouple, la variation rapport d'intensité des pics H et S après correction de la contribution de l'absorption du graphite, et la température interne $T_{int}$ calculée à partir de la courbe de calibration du capteur de thermo-luminescence, comme illustré à la figure 22.

D'autres variantes et améliorations peuvent être envisagées sans pour autant sortir du cadre de l'invention.

Le capteur 7 selon l'exemple illustré est réalisé selon les techniques, notamment par sol-gel selon la demande de brevet EP4155700A1. L'invention peut s'appliquer à tout autre type de sonde optique de thermoluminescence utilisant un autre type de particules ou de molécules en tant que luminophores et un autre type de matériau pour la matrice avec au moins deux pics d'émission dont un constant à la température et l'autre dans une zone d'absorption optique, de préférence dans une zone de forte variation de celle-ci dépendante de l'état de lithiation, de manière plus générale de l'état d'insertion de matériau d'insertion d'une électrode dans un accumulateur métal-ion.

Ainsi, si l'invention a été décrite en relation avec une électrode négative en graphite, le capteur selon l'invention peut tout-à-fait être mis en oeuvre dans un accumulateur métal-ion à autre chimie des matériaux d'anode ou de cathode dans la mesure où ce(s) matériau(x) présente une absorption optique qi change avec son état de charge et si ce changement peut se mesurer de la même façon sans perturber la mesure de la température par thermoluminescence.

Pour la réalisation du capteur, on peut envisager d'autres matériaux dits matériaux « up-converters » qui ont des propriétés de thermoluminescence.

**Liste des références citées :**

[1]:https ://battery2030.eu/research/roadmap/

[2]: https://www.instabat.eu/

[3]: Wang, R., Zhang, H., Liu, Q., Liu, F., Han, X., Liu, X., Li, K., Xiao, G., Albert, J., Lu, X. & Guo, T. « Operando monitoring of ion activities in aqueous batteries with plasmonic fiber-optic sensors » Nature Communications 13, 547 (2022).

[4]: Lu, X., Tarascon, J.-M. & Huang, J. « Perspective on commercializing smart sensing for batteries ». eTransportation 14, 100207 (2022).Wang, R., Zhang, H., Liu, Q., Liu, F., Han.

[5]: Hedman, J., Mogensen, R., Younesi, R. & Björefors, F. « Fiber Optic Sensors for Détection of Sodium Plating in Sodium-Ion Batteries ». ACS Applied Energy Materials (2022) doi:10.1021/acsaem.2c00595.

[6]: Ghannoum, A., Norris, R. C., Iyer, K., Zdravkova, L., Yu, A. & Nieva, P. « Optical Characterization of Commercial Lithiated Graphite Battery Electrodes and in Situ Fiber Optic Evanescent Wave Spectroscopy. » ACS Applied Materials and Interfaces 8, 18763-18769 (2016).

[7]: Ghannoum, A., Iyer, K., Nieva, P. & Khajepour, A. « Fiber optic monitoring of lithium-ion batteries: A novel tool to understand the lithiation of batteries ». in Proceedings of IEEE Sensors (2017). doi:10.1109/ICSENS.2016.7808695.

[8]: Ghannoum, A., Nieva, P., Yu, A. & Khajepour, A. « Development of Embedded Fiber-Optic Evanescent Wave Sensors for Optical Characterization of Graphite Anodes in Lithium-Ion Batteries. » ACS Appl. Mater. Interfaces 9, 41284-41290 (2017).

[9]: Ghannoum, A. & Nieva, P. « Graphite lithiation and capacityfade monitoring of lithium ion batteries using optical fibers. » Journal of Energy Storage 28, 101233 (2020)

[10]: Modrzynski, C., Roscher, V., Rittweger, F., Ghannoum, A., Nieva, P. & Riemschneider, K. « Integrated Optical Fibers for Simultaneous Monitoring of the Anode and the Cathode in Lithium Ion Batteries. » in 2019 IEEE SENSORS 1-4 (2019). doi:10.1109/SENSORS43011.2019.8956755.

**Revendications**

1. Capteur (7) de température et de mesure de l'état de charge (SOC) d'un accumulateur notamment métal-ion, comprenant une fibre optique (8) dont une extrémité libre (82) forme une sonde optique (9) à matériau(x) thermo-luminescent(s) (91) susceptible(s) d'émettre un pic de lumière à au moins deux longueurs d'ondes, au moins un des deux pics étant adapté pour être dans au moins une zone de variation du spectre d'absorption optique du matériau d'insertion des ions métal d'au moins une électrode de l'accumulateur, le rapport des deux pics étant fonction de la température de l'accumulateur et la variation d'intensité d'au moins un des deux pics étant fonction de l'insertion des ions métal dans l'électrode.

2. Capteur selon la revendication 1, la longueur d'onde d'un des deux pics d'émission étant au-dessus de 700 nm, de préférence entre 700 et 1100 nm, tandis que celle de l'autre des deux pics d'émission est au-dessous de 700 nm, de préférence entre 400 et 600 nm.

3. Capteur selon la revendication 1 ou 2, la sonde optique comprenant une matrice (90) dans laquelle sont incorporées des particules (91) en au moins un matériau thermo-luminescent.

4. Capteur selon l'une des revendications précédentes, le matériau thermo-luminescent étant Gd2O2S ou $Y_2O_2S$ dopé Er3+ et Yb3+.

5. Accumulateur (A) ou batterie métal-ion, notamment li-ion, comprenant, inséré en son sein, au moins un capteur (7) selon l'une des revendications 1 à 4.

6. Accumulateur selon la revendication 5, le capteur étant directement en contact avec l'électrode dont l'état de lithiation varie.

7. Accumulateur selon la revendication 5, le capteur étant directement en contact avec la face du séparateur de l'accumulateur qui est opposée à celle en contact avec l'électrode dont l'état de lithiation varie.

8. Accumulateur selon la revendication 5, le capteur étant inséré dans le séparateur ou pris en sandwich entre deux couches de séparateur de l'accumulateur.

9. Utilisation d'un capteur selon l'une des revendications 1 à 4, pour la mesure de température simultanée à la mesure de l'état d'insertion des ions au sein d'un accumulateur métal-ion, notamment de l'état de lithiation d'une électrode négative en graphite d'un accumulateur Li-ion.

[Fig 1]

Fig. 1
(ETAT DE L'ART)

[Fig 2]

Fig. 2
(ETAT DE L'ART)

[Fig 3]

Fig. 3

[Fig 4]

$Y = -1,04 \times 10^1 X + 1,71$

Fig. 4

[Fig 5]

Fig. 5

[Fig 6]

Fig. 6

[Fig 7]

Niveau IV  Niveau III  Niveau II

40%    50%    70%    75%    80%

Fig. 7

[Fig 8]

Fig. 8

[Fig 9]

Fig. 9

[Fig 10]

Fig. 10

[Fig 11]

Pic 2

Pic 1

Intensité (a.u)

Longueur d'onde (a.u)

Lithiation du graphite

## Fig. 11

[Fig 12]

Gamme de forte variation
de l'absorption en fonction
de l'état lithiation du graphite

Pic 2

Pic 3

Pic 1

Intensité (a.u)

T↗

Lithiation du graphite

Longueur d'onde (a.u)

## Fig. 12

[Fig 13]

Fig. 13

[Fig 14A]

Environnement

Fig. 14A

[Fig 14B]

Fig. 14B

[Fig 14C]

Fig. 14C

[Fig 14D]

Fig. 14D

[Fig 14E]

Fig. 14E

[Fig 15]

Fig. 15

[Fig 16]

Fig. 16

[Fig 17A]

Fig. 17A

[Fig 17B]

Fig. 17B

[Fig 17C]

Fig. 17C

[Fig 18]

Fig. 18

[Fig 19]

Fig. 19

[Fig 20]

Fig. 20

[Fig 21]

Fig. 21

[Fig 22]

Fig. 22

Europäisches
Patentamt

European
Patent Office

Office européen
des brevets

# RAPPORT DE RECHERCHE EUROPEENNE

**Numéro de la demande**

EP 24 21 8721

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 10 589 629 B2 (GM GLOBAL TECH OPERATIONS LLC [US]) 17 mars 2020 (2020-03-17) * abrégé * * colonne 1, ligne 20 - colonne 2, ligne 7 * ----- | 1-9 | INV. G01K11/3213 |
| A,D | EP 4 155 700 A1 (COMMISSARIAT ENERGIE ATOMIQUE [FR]) 29 mars 2023 (2023-03-29) * abrégé * * alinéas [0001] - [0008], [0012] * ----- | 1-9 | |
| A,D | GHANNOUM ABDULRAHMAN ET AL: "Optical Characterization of Commercial Lithiated Graphite Battery Electrodes and in Situ Fiber Optic Evanescent Wave Spectroscopy", APPLIED MATERIALS & INTERFACES , vol. 8, no. 29 13 juillet 2016 (2016-07-13), pages 18763-18769, XP093003686, US ISSN: 1944-8244, DOI: 10.1021/acsami.6b03638 Extrait de l'Internet: URL:https://pubs.acs.org/doi/pdf/10.1021/acsami.6b03638 * abrégé * * le document en entier * ----- | 1-9 | DOMAINES TECHNIQUES RECHERCHES (IPC) G01K |

Le présent rapport a été établi pour toutes les revendications

| Lieu de la recherche | Date d'achèvement de la recherche | Examinateur |
|---|---|---|
| La Haye | 8 mai 2025 | Bagnera, Carlo |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 21 8721

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-05-2025

| Document brevet cité au rapport de recherche | | Date de publication | Membre(s) de la famille de brevet(s) | | Date de publication |
|---|---|---|---|---|---|
| US 10589629 | B2 | 17-03-2020 | CN | 107817286 A | 20-03-2018 |
| | | | DE | 102017216187 A1 | 15-03-2018 |
| | | | US | 2018072159 A1 | 15-03-2018 |
| EP 4155700 | A1 | 29-03-2023 | EP | 4155700 A1 | 29-03-2023 |
| | | | FR | 3127590 A1 | 31-03-2023 |
| | | | US | 2023096388 A1 | 30-03-2023 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 20060121348 A
- US 7348098 B
- US 7338733 B
- US 2008060189 A
- US 20080057392 A
- US 7335448 B
- EP 4155700 A1

### Littérature non-brevet citée dans la description

- **WANG, R.** ; **ZHANG, H.** ; **LIU, Q.** ; **LIU, F.** ; **HAN, X.** ; **LIU, X.** ; **LI, K.** ; **XIAO, G.** ; **ALBERT, J.** ; **LU, X.** Operando monitoring of ion activities in aqueous batteries with plasmonic fiber-optic sensors. *Nature Communications*, 2022, vol. 13, 547
- **LU, X.** ; **TARASCON, J.-M.** ; **HUANG, J.** Perspective on commercializing smart sensing for batteries. *eTransportation*, 2022, vol. 14, 100207
- **HEDMAN, J.** ; **MOGENSEN, R.** ; **YOUNESI, R.** ; **BJÖREFORS, F.** Fiber Optic Sensors for Détection of Sodium Plating in Sodium-Ion Batteries. *ACS Applied Energy Materials*, 2022
- **GHANNOUM, A.** ; **NORRIS, R. C.** ; **IYER, K.** ; **ZDRAVKOVA, L.** ; **YU, A.** ; **NIEVA, P.** Optical Characterization of Commercial Lithiated Graphite Battery Electrodes and in Situ Fiber Optic Evanescent Wave Spectroscopy.. *ACS Applied Materials and Interfaces*, 2016, vol. 8, 18763-18769
- **GHANNOUM, A.** ; **IYER, K.** ; **NIEVA, P.** ; **KHAJEPOUR, A.** Fiber optic monitoring of lithium-ion batteries: A novel tool to understand the lithiation of batteries. *Proceedings of IEEE Sensors*, 2017
- **GHANNOUM, A.** ; **NIEVA, P.** ; **YU, A.** ; **KHAJEPOUR, A.** Development of Embedded Fiber-Optic Evanescent Wave Sensors for Optical Characterization of Graphite Anodes in Lithium-Ion Batteries.. *ACS Appl. Mater. Interfaces*, 2017, vol. 9, 41284-41290
- **GHANNOUM, A.** ; **NIEVA, P.** Graphite lithiation and capacityfade monitoring of lithium ion batteries using optical fibers.. *Journal of Energy Storage*, 2020, vol. 28, 101233
- **MODRZYNSKI, C.** ; **ROSCHER, V.** ; **RITTWEGER, F.** ; **GHANNOUM, A.** ; **NIEVA, P.** ; **RIEMSCHNEIDER, K.** Integrated Optical Fibers for Simultaneous Monitoring of the Anode and the Cathode in Lithium Ion Batteries.. *2019 IEEE SENSORS*, 2019, vol. 1-4